# EUROPEAN PATENT APPLICATION

(11) **EP 2 169 416 A1**
(43) Date of publication of application: **31.03.2010**
(21) Application number: 08017182.0
(22) Date of filing: 30.09.2008
(51) Int. Cl.: G01R 33/54

(54) **Method for automatic detection of artefacts in in vivo human brain MRI images**

(71) Applicant: Siemens Schweiz AG, 8047 Zürich (CH)
(72) Inventor: Mortamet, Bènédicte, 1003 Lausanne (CH); Krueger, Gunnar, 1007 Lausanne (CH)
(74) Representative: Fischer, Michael

(57) **Abstract**

A method for detecting artefacts in single time-point in vivo MRI imaging data of human brain is proposed, whereby:
- at least one in-vivo image is acquired by means of an MRI imaging apparatus,
- a background image corresponding to the imaged air of said in-vivo image is obtained,
- said background image is obtained in two steps, a first step comprising establishing of an object-air boundary, a second step consisting in an atlas-based refinement of a background volume of interest,
- art histogram (H) that reflects an intensity distribution of the background image is obtained,
- said background image consists of a set of voxels where artifacts are detected,
- intensities above a definable intensity value (*t₁*) provides an initial estimate
of a range of artifacts intensities,
- a modified morphological opening operation is executed, consisting in an erosion of a set of voxels and a dilation, performed iteratively and constrained to voxels intensity above the intensity value (*t₁*) so that said opening operation provides natural definition of artefacts regions.

## Description

The invention relates to a method for automatic detection of data in in-vivo images according to claim 1.

The proposed invention intends to achieve artifacts detection in single time-point in vivo imaging data in an automated manner and especially MR based data (Magnetic Resonance based imaging data). Sufficiently good MR imaging quality is a prerequisite to derive diagnostic information with high reliability. Standard quality assurance (abbreviated with QA) protocols are based on specially designed phantoms and include analysis of image quality-related system parameters such as gradient linearity, geometric accuracy, high-contrast resolution, slice thickness/position accuracy, image intensity uniformity, percent signal ghosting and low-contrast object detectability. Although these QA tests are mandatory and standard procedure during tune-up and service of MR systems on clinical scanners to detect machine-specific artifacts, none automated program to analyze effectively patient-related artifacts is used in practice.

Signal-to-noise ratio (abbreviated with SNR) has traditionally been presented as an important index of image quality in magnitude human MR images. A signal is typically measured as the mean intensity within a region of interest in the imaged object (e.g. brain tissue) whereas it is natural to look for noise on a region (called background) of the image with no signal, that is, over air (see references [1], [2]). SNR measures, however, are not necessarily sensitive to patient-induced artifacts that often manifest as signal intensity being mis-mapped to an incorrect spatial location relative to tissues being imaged. Major types of patient-related artifacts are: edge artifacts (chemical shifts, ringing, ghosting from motion), flow artifacts, aliasing (wraparound from improper patient positioning and protocol planning e.g. nose wrap) artifacts (see references [3] to [6]).

One goal underlying to be achieved is to be seen in detecting artifacts in single time-point in vivo imaging data in an effective automated manner, especially for MR based imaging data.

Over an imaging process, most of artifacts based detection signal intensities arise and propagate into a so called background (like noise in opposite to a effective signal). The invention uses the fact that a careful analysis of this background therefore can provide sufficient information to detect a presence of artifacts and derive sensitive quality index from patient magnitude images. The present method according to the invention provides hence an automatic-able technique to define a background or ROIs of background (ROI = Region Of Interest) from a single image which is able to be used to automatically derive effectively quality measures.

Based on a single image (associated to a complex, magnitude image or a frequency based so called "k-space" data), the proposed invention automates the detection of patient-induced artifacts and allows the classification of data quality prospectively or retrospectively.

The present invention proposes hence a method for detecting in single time-point in vivo imaging data, especially artifacts (see above), in an automated manner according to claim 1.

The main advantage of the proposed method according to the invention is that it allows to automatically derive quality measures from e.g. a MR image (like images of a human brain). It is a mean to test the eligibility of data to further guarantee accurate and reproducible post-processing measures such as brain tissue classification.
Further advantages of this invention rely in that
a) this method, if applied just after a scan session and ideally incorporated in image reconstruction may eventually inform a MR operator about the low-quality directly after the scan and advise the need to rescan while the patient is still in a MR bore. Consequently, the number of call-back examinations and thus overall patient burden could be reduced,
b) because the proposed invention is automated, it offers perfect repeatability, unlike human graders, where inter- and intra-observer repeatability is an issue,
c) this method can directly be extended to data with other contrasts, using parallel-imaging techniques or corrected for various MR-related intensity inhomogeneities or geometrical distortions (e.g. by known B1-intensity variation of a phased array receive coils, RF magnetic field imperfections, gradient coil nonlinearities).

According to the invention, the method for automatic detection and hence for quality control of a single human brain MR image is achieved in a two-step process based on:
- (1) a background air region delineation and
- (2) a detection of artifactual voxels.

Firstly, background air region delineation is performed by means of a first step (a) segmentation of the whole head (as a human part of body) and a second step (b) refinement of the volume of interest (abbreviated with VOI).
The first step (a) is based on the establishment of scalp/air boundary by means of computation on a magnitude gradient image. Such a transition is quite sharp and can be enhanced by a preliminary anisotropic diffusion filtering. To exclude non-scalp/air boundary voxels, a threshold is computed, from the magnitude gradient image histogram, which is defined as the intensity corresponding to a small amount (e.g. 1%) of the number of non-zero voxels in the image (empirically defined frequency threshold), This thresholding produces a set of voxels belonging to the outer scalp boundary refined by a closing operation. Then a hole-filling process creates a single volume containing the entire head. Because the goal relies in detecting artifacts that cause signal fluctuations in brain tissue (i.e. we are not interested in artifacts affecting the neck region), a restriction is providing in a background noise analysis to a VOI above the plane passing through a nasion-to-posterior-of-the-cerebellum line and perpendicular to a correspondding sagittal plane. The VOI is codified in a home-built so called T1-weighted magnetic resonance image template (i.e. an image obtained by an imaging technique based on a spin lattice relaxation also called longitudinal relaxation or abbreviated with T1). This template is aligned to a subject scan with a 12-parameters affine transformation during said step (b). Finally, regions below this plane are appended to a head mask resulting from step (a) and a background image is finally obtained after exclusive masking.
Secondly, a detection of artifactual voxels is performed over all voxels defined in the previous background mask. For purposes of clarity, let us index *N* image voxels *i* belonging to a background with *i ∈ S*=*{1,2,...,N}* and denote the intensity of voxel *i* by *xᵢ* and background intensity histogram by *H*. Artifacts intensities overlap with true noise ones, so a primary concern is to define a threshold to remove low-intensity noise in the background. An intensity *t1* at maximal amplitude of *H* gives an initial estimate of the range of artifacts intensities. A thresholding produces a volume with a set of voxels described as *Xₜ₁ = {i ∈ S: xᵢ* > *t₁}.* After thresholding, said volume still contains voxels with intensity due to true noise and randomly scattered through the volume. To remove the remaining noise, a modified morphological opening operation (see examples in references [7], [8]), consisting in an erosion of the set of voxels *Xₜ₁* using a 3D cross structuring element, and a dilation, performed iteratively with the same kernel and constrained to voxels intensity above the intensity *t₁*. The result of this process is a natural definition of artifacts regions where statistics can be performed. For example, the proportion of voxels with intensity that is corrupted by artifacts and normalized by the background size is advantageously a sensitive quality index.
In a further step, the previous method can be tuned to be more specific to particular artifact pattern (e.g. eye movement, creates artifacts only along the phase-encoding direction). Introducing models with prior-knowledge about spatial pattern of different artifacts sources may allow a more detailed analysis as well as a better classification and further detection of all artefacts.

In resume, the method for detecting in single time-point in vivo imaging data related to artefacts in said imaging of at least one object (like applied to an imaging of a head with brain as tissues and moving eyes as artefacts) according to the invention consists in following main steps and features:
- at least one in-vivo image is acquired by means of an imaging apparatus,
- a background image corresponding to the imaged air of said in-vivo image,
- said background image is obtained in two steps, a first step comprising establishing of an object-air boundary, a second step consisting in an atlas-based refinement of a background volume of interest,
- an histogram (H) that reflects an intensity distribution of the background image,
- said background image consists of a set of voxels where artifacts are detected,
- intensities above a definable intensity value (*t₁*) provides an initial estimate of a range of artifacts intensities,
- a modified morphological opening operation is executed, consisting in an erosion of a set of voxels and a dilation, performed iteratively and constrained to voxels intensity above the intensity value (*t₁*) so that said opening operation provides natural definition of artefacts regions,
- the background image is provided over a data processing based on spacial or frequency coordinates,
- said definition of artifacts regions is used to perform statistical analysis and derive sensitive quality indices on artefacts characteristics, such as a proportion of voxels with intensities corrupted by artifacts, a mean intensity and/or a standard deviation of these artifactual voxels.

Due to this method, it is hence advantageously possible to detect effectively artefacts that can impair the quality of an imaging. If such artefacts are detected, it is also possible to filter out the voxels related to said artefact, so that only the parts of imaged object (free of artefacts) remain with a quality optimized imaging.

The described methods are further explained by the following examples and drawings, (especially relating to background based segmentation) whereby:
- Drawing 1: shows a first step of segmentation of a head MR-image,
- Drawing 2: shows a second step of VOI-refinement of a head MR-image.

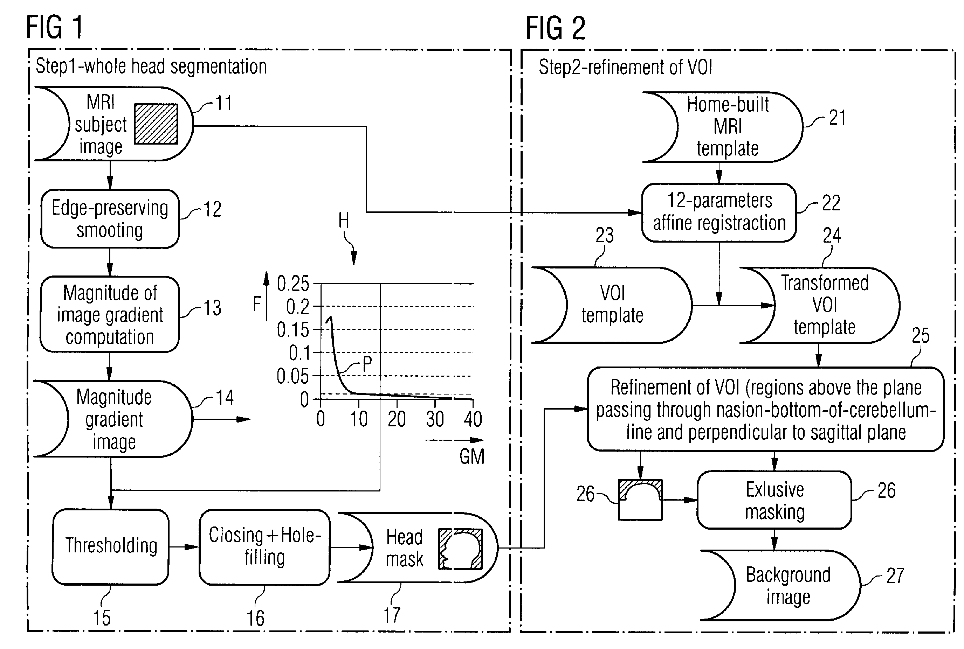

**Drawing 1** presents a first step of segmentation of a head MR-image according to the present invention. After imaging the head (step 11) by means of MR-imaging means, the imaging data are smoothed under edge-preserving (step 12) and a gradient image is created from which the magnitude is computed (step 13). A final magnitude gradient image (step 14) is hence obtained for which a thresholding (steps 15) by means of previously mentioned definable intensity value is executed in addition to a closing and hole-filing-processing (step 16) in order to get a mask of head image (step 17). That permits to establish an histogram H (frequency F - or number of voxels normalized by image size - against the gradient magnitude GM). Under a selected threshold value TV of gradient magnitude GM, a peak P of frequency related to scalp/air boundary gradient magnitudes can be monitored (detected) as indicator of presence of tissue (considered to be head in this example).

**Drawing 2** is related to drawing 1 and presents a complementary, said second step of VOI-refinement of the previous head MR-image. From a home-built MR-Imaging template (bloc 21), an affine transformation or registration comprising e.g. 12 parameters (bloc 22) performs said transformation on imaged head (intensity) data from step 11 of drawing 1. An additional predefined template of VOIs (bloc 23) is transformed (step 24) according to the transformed head image (intensity) data. By means of the data of head mask from step 17, that is conditioned by the previous thresholding according to drawing 1, it is hence possible to refine (step 25) the region(s) of interest of said mask in view of restricting the detection of artifacts to specific regions, for example in regions above the plane passing through nasion-bottom-of-cerebellum-line and perpendicular to sagittal plane. By this way, an further exclusive mask (bloc 26) can be provided in order to deliver a well-suited background image (bloc 27) that is necessary for implementing the method of detection according to the invention.

### References

[1] Kaufman L, Kramer DM, Crooks LE, Ortendahl DA. Measuring signal-to-noise ratios in MR imaging. Radiology 1989;173(1):265-267.
[2] Henkelman RM. Measurement of signal intensities in the presence of noise in MR images. Med Phys 1985;12(2):232-233.
[3] Mirowitz SA. MR imaging artifacts. Challenges and solutions. Magn Reson Imaging Clin N Am 1999;7(4):717-732.
[4] Clark JA, 2nd, Kelly WM. Common artifacts encountered in magnetic resonance imaging. Radiol Clin North Am 1988;26(5):893-920.
[5] Hedley M, Yan H. Motion artifact suppression: a review of post-processing techniques. Magn Reson imaging 1992;10(4):627-635..
[6] Saloner D. Flow and motion. Magn Reson Imaging Clin N Am 1999;7(4):699-715.
[7] Serra J. Image Analysis and Mathematical Morphology: Academic Press, Inc. Orlando, FL, USA; 1983.
[8] Haralick RM, Stemberg SS, Zhuang X. Image analysis using mathematical morphology. IEEE Transactions on Pattern Analysis and Machine Intelligence 1987;9(4):532-550.

## Claims

1. Method for detecting in single time-point in vivo imaging data related to artefacts in said imaging of objects, whereby:
- at least one in-vivo image is acquired by means of an imaging apparatus,
- a background image corresponding to the imaged air of said in-vivo image,
- said background image is obtained in two steps, a first step comprising establishing of an object-air boundary, a second step consisting in an atlas-based refinement of a background volume of interest,
- an histogram (H) that reflects an intensity distribution of the background image,
- said background image consists of a set of voxels where artifacts are detected,
- intensities above a definable intensity value (*t₁*) provides an initial estimate of a range of artifacts intensities.
- a modified morphological opening operation is executed, consisting in an erosion of a set of voxels and a dilation, performed iteratively and constrained to voxels intensity above the intensity value (*t₁*) so that said opening operation provides natural definition of artefacts regions.

2. Method according to claim 1, whereby the background image is provided over a data processing based on spacial or frequency coordinates.

3. Method according to claim 1 or 2, whereby said definition of artifacts regions is used to perform statistical analysis and derive sensitive quality indices on artefacts characteristics, such as a proportion of voxels with intensities corrupted by artifacts, a mean intensity and/or a standard deviation of these artifactual voxels.
